# EUROPEAN PATENT APPLICATION

(11) **EP 3 907 723 A1**
(43) Date of publication of application: **10.11.2021**
(21) Application number: 19925659.5
(22) Date of filing: 16.05.2019
(51) Int. Cl.: G09F 3/00, G01N 21/87

(54) **OPTICALLY TRANSPARENT MARK FOR MARKING GEMSTONES**

(30) Priority: 23.04.2019 RU 2019112399
(71) Applicant: Joint Stock Company «Alrosa» (Public Joint Stock Company) (PJSC Alrosa), G. Mirny, 678175, Republic of Sakha (Yakutia) (RU)
(72) Inventor: IONIN, Andrey Alekseevich, Moscow, 117335 (RU); KUDRYASHOV, Sergey Ivanovich, Pushkino, 141207 (RU); SMIRNOV, Nikita Aleksandrovich, Moscow, 117279 (RU); DANILOV, Pavel Aleksandrovich, Zheleznogorsk, 307170 (RU); LEVCHENKO, Aleksey Olegovich, Elektrostal, 144012 (RU)
(74) Representative: Plasseraud IP
(86) International application number: PCT/RU2019/000344
(87) International publication number: WO 2020/218940

(57) **Abstract**

The invention relates to marks used for marking gemstones, including diamonds or brilliants, and carrying information for various purposes, for example, identification codes, in particular to the marks that are invisible to the naked eye, using magnifying glasses and various types of microscopes, in particular, to the marks located inside the volume of diamonds or brilliants without affecting their characteristics, resulting in damage to the quality of diamonds or brilliants. The technical problem of the claimed solution is to expand the scope of use of the mark on diamonds with different content of natural impurities including nitrogen, to achieve a technical result consisting in solving said problem while simplifying the marking process and reducing possible affecting properties of the stone during marking. Said technical result is achieved by the use of an optically permeable mark located inside the diamond or brilliant volume, which mark contains predefined encoded information and consists of a given set of optically permeable elements of micron or submicron size, which represent areas of increased concentration of atomic defects in the diamond or brilliant crystal lattice, wherein atomic defects in the diamond or brilliant crystal lattice are vacancies and interstitials, wherein said information is encoded in at least two areas of increased concentration of said atomic defects. The information is encoded in the mutual spatial arrangement of said areas, in variations in the concentration of atomic defects in said areas, in variations in the size or geometrical shape of said areas, which areas are created by exposing the diamond to optical radiation focused in the focal region located in the region of the expected location of said mark areas. 4 d.c., 3 ill.

## Description

The present invention relates to marks used for gemstone marking, including diamonds and brilliants, and carrying information for various purposes, for example, known only to a small circle of people, for example identification codes, in particular, to marks invisible to the naked eye, using magnifying glasses and microscopes of various types inside faceted (brilliants) and uncut natural or synthetic diamonds (hereinafter referred to as diamonds) without affecting their characteristics, resulting in damage to the quality of the diamonds.

The problem of creating images in the volume of diamond crystal, for example, for marking diamonds in order to identify and track them, without prejudice to their quality and, consequently, cost, is well known, since some properties of diamonds make creating such images very difficult.

It is known that diamonds are optically transparent for wavelengths in the visible spectrum in the range 400-700 nm, that diamond is a material of very high hardness, prone to cracking under severe mechanical stress or excessive local heating, and therefore, images of the mark, preferably in the form of readable codes, samples, serial numbers, and sequences of alphanumeric characters, must be invisible or very small and inaccessible to mechanical and chemical effects, in order to avoid unauthorized detection or removal, and also must not alter the appearance and commercial value of the diamond.

Various types of marks are known for applying to a surface of the faceted diamond. However, facets of the faceted diamond surface are oriented in different directions, have very small dimensions, and may not be accessible for marking and detection if the gemstone is inserted into the frame. In addition, surface marks can be destroyed by mechanical and chemical treatment, for example, polishing, etching. Therefore, it is preferable, especially for expensive diamonds, to create marking images under the surface layer of diamond without changing the outer surface.

The creation of two- and three-dimensional images in the volume of diamond is a promising technology both for the purpose of storing information and for use in optical technology.

Marks are known that are opaque to optical radiation, created due to the development of the volume of disturbed diamond microstructures surrounding natural impurities, or due to the incorporation of impurity ions, for example, phosphorus, into the diamond structure, which creates detectable defective regions.

A mark obtained in diamonds by a method (RU 2357870 C1; WO 2006/092035; US 7284396 B1) and system for laser marking of diamonds is known, wherein engraving authentication codes is proposed in the form of marks in the diamond volume created by exposure to a controlled train of laser pulses in the femtosecond range (from several femtoseconds to 200 picoseconds) with energy of each laser pulse above the threshold for damage to the diamond crystal. In this case, damage was initiated by defects or impurities (nitrogen, hydrogen, sulfur, phosphorus, nickel, and boron atoms, and others) present in the bulk of the material where the recording laser beam reaches its smallest transverse size and maximum intensity. In this case, the radiation is focused in the diamond volume, resulting in the formation, in the places of random distribution of the specified defects, of growing defective microstructures that are opaque to optical radiation. The signs consist of non-diamond forms of carbon and are formed from several microscopic point marks with a size of several micrometers (2-5 µm) with a distance between adjacent point marks of about 50 µm, and wherein the array of point marks has an area of 250 × 250 µm, and require the use of a special detection device for readout. However, at the same time:
- created point marks are larger than natural defects in diamond, thereby deteriorating the quality and commercial value of diamonds;
- the mutual arrangement of the points in the mark can determine only some geometric combination thereof, for example, the vertices of a virtual triangle based on three points, but not the image of the triangle itself;
- stone authentication based on the mutual spatial arrangement of the point marks therein created in the rough diamond cannot be reliable after its faceting, when the position of the part of the point marks relative to the facets and between them can be changed;
- due to a stochastic arrangement of natural defects in diamond, the creation of miniature images having a visual and semantic charge is impossible.

A mark obtained in transparent materials by a method (SU 329899 A) is known, in which a latent image was created in transparent diamond plates having dimensions of 50 × 50 mm and a thickness of 300 µm. A metal mask with a thickness of 50 µm was applied onto the surface of such a sample, wherein the required image had been etched in the mask using photolithography, after which the sample was bombarded with phosphorus ions. In such a case, in addition to the color surface image, an internal image appeared, and then the plates were subjected to subsequent thermal annealing, as a result of which the color image disappeared. The formed image was thermally stable up to 1200 °C, not destroyed by the action of light, electric and magnetic fields. However, due to the high lattice hardness, the depth of penetration of phosphorus ions into the diamond and the depth of the internal image placement cannot be large, therefore, a thin surface layer containing the mark can be removed by polishing or etching, and also an increase in the amount of phosphorus impurities in the diamond and the presence of the visually distinguishable image affects its commercial value.

A mark is known obtained in the synthesis of diamonds by chemical vapor deposition from the gas (vapor) phase by a method (RU 2382122 C1), in which at least one dopant of a chemical element, for example nitrogen, in the form of defective centers emitting radiation with a characteristic wavelength upon excitation, is incorporated in the layer of synthetic diamond material. In this case, the dopant forms a production mark or identification mark in the form of a layer in which fluorescence with peaks of 575 nm and/or 637 nm occurs upon appropriate optical excitation, which fluorescence disappears almost instantly when the excitation source is turned off. Recognition (detection) of the production mark or identification mark can be carried out, for example, visually or using special optical devices. In general, it is preferable that observer recognizes it directly with the naked eye, since this method allows to obtain spatial information, in particular binocular or in-depth information.

However, it is well known that the capture of impurities varies depending on the growth sector involved in this process, for example the growth sector {111} often captures a higher concentration of impurities than the growth sector {100}, distorting the created mark. In addition, in this method of marking synthetic grown diamonds, additional impurities, defects are introduced into the diamond, which does not improve the quality of the diamond.

In addition, said mark cannot be used for marking natural diamonds or artificial diamonds grown using other technologies.

Marks comprising diamond nanocrystals with active centers fluorescent under influence of external radiation are known to be used in article protection methods: NV centers (RU 2357866 C1) or N-E8 centers (RU 2386542 C1) obtained by exposing diamond nanocrystals to an electron or ion beam with subsequent annealing at high temperature, which results in the formation of NV centers or N-E8 centers located relatively uniformly in the entire volume of the nanocrystal. Then, nanocrystals containing the specified optically active centers are introduced into the article, and the presence or absence of the mark is judged by the presence of fluorescence and or double radio-optical resonance upon exciting optical radiation.

It is known that the detection of such fluorescence emission of NV centers (RU 2357866 C1) can be carried out in a device comprising an optical excitation source with a wavelength in the range of 500-550 nm, for example by radiation of the second harmonic of a yttrium-aluminum garnet laser (532 nm) activating the NV centers and causing them to fluoresce, and a photo detector tuned to wavelengths in the range of 630-800 nm, which analyzes the spectral and temporal characteristics of the obtained fluorescence signal.

In such a case, the conclusion about the presence of such a mark in the article is made on the basis of the spectral characteristics of fluorescence corresponding to the known spectral characteristics of the fluorescence of the NV center and the difference in the fluorescence signal when simultaneously excited with and without a resonant microwave field, which indicates the presence of a diamond having the NV centers in the article.

However, mark consisting of diamond nanocrystals enriched with N-V or N-E8 centers can be effectively used on objects having a relatively porous surface, in the pores of which nanodiamonds are effectively retained. Nanodiamonds can be easily removed from the smooth polished surface of a faceted diamond.

The closest analogue is a mark created using a method for creation of an optically permeable image inside a diamond (RU2465377), which consists in creating an image inside the diamond, which image consists of a given set of optically permeable elements of micron or submicron size, which are clusters of NV centers that fluoresce upon exciting radiation, wherein clusters of NV centers are formed by performing the following operations: treatment of the diamond with working optical radiation focused in the focal region located in the area of the expected location of the cluster of NV centers, with supplying of working ultrashort radiation pulses providing the formation of a vacancy cluster in the specified focal region, wherein an integrated fluence below the threshold fluence, at which the local transformation of diamond into graphite or another non-diamond form of carbon occurs, is provided in the specified focal region; annealing at least the specified areas of the expected location of clusters of N-V centers, which provides a drift of created vacancies in these regions and the formation of N-V centers grouped in clusters in the same areas as vacancy clusters; control the created image elements based on the registration of fluorescence of N-V centers upon irradiation of at least areas of the location of image elements with exciting optical radiation providing excitation of the N-V centers; forming of a digital and/or three-dimensional model of the created image. Images created in diamond crystals from clusters of N-V centers are invisible to the naked eye, through magnifying glasses, an also with optical or electron microscopes of any type.

However, the mark cannot be created by this method in diamonds in which there is no (or very small) natural admixture of nitrogen, since forming of clusters of NV centers is not ensured, while with a high concentration of impurities in the diamond, the so-called concentration quenching of fluorescence or the absence of significant drift of vacancies due to their capture by closely spaced defects is observed.

The technical problem of the claimed solution is to expand the scope of the mark use on diamonds with different content of natural impurities including nitrogen, to achieve a technical result consisting in solving said problem while simplifying the marking process and reducing the possible affecting properties of the stone during marking.

Said technical result is achieved by the use of an optically permeable mark located inside the diamond or brilliant volume, which mark contains predefined encoded information and consists of a given set of optically permeable elements of micron or submicron size, which are areas of increased concentration of atomic defects in the diamond or brilliant crystal lattice, wherein atomic defects in the diamond or brilliant crystal lattice are vacancies and interstitials, and wherein the specified information is encoded in at least two areas of increased concentration of said atomic defects.

An additional feature is that the information is encoded in the mutual spatial arrangement of said areas.

An additional feature is that the information is encoded in variations in the concentration of said atomic defects in said areas.

An additional feature is that the information is encoded in variations in the size of said areas.

An additional feature is that the information is encoded in variations of the geometric shape of said areas.

The physical effects associated with the accumulation of atomic defects in transparent crystals under the action of laser pulses with high peak power were reported back in the 1980s after the creation of relatively powerful lasers in the picosecond and subpicosecond ranges. With repeated exposure to laser pulses, an increase in absorption and a gradual decrease in the radiation strength of the crystal were observed. In this case, no changes in the crystal were visually observed until its optical breakdown.

Later, laser-induced accumulation of defects in crystals was investigated from the point of view of laser processing of materials. In [Kononenko et al, Microprocessing of the diamond volume by infrared femtosecond laser pulses // Applied physics A. 2008. Vol. 90. P. 645], the "incubation" effect is noted, representing an optical damage to diamond after exposure to many laser pulses. The authors attribute this effect to the "appearance and accumulation of stable nanoscale defects."

In modern scientific literature, these effects are associated with the accumulation of atomic defects in the crystal lattice, i.e. vacancies and interstitials, in a diamond crystal.

To form an optically permeable mark in the diamond volume according to the present invention laser pulses of the visible or near infrared range of the femto- or picosecond duration are focused inside the volume at a predetermined depth. In the focus region, where the highest intensities are reached, the electrons are detached from the electron shells of atoms and the electron-hole plasma is formed. If the laser pulse energy is not large, then the density and temperature of such plasma is insufficient for irreversible macroscopic damage to the crystal with the formation of non-diamond forms of carbon (graphite, amorphous carbon), cracks, etc. In this case, there is no visible damage to the crystal; however, during the interaction of said plasma with the atoms of the crystal lattice, there is a probability of transition of individual atoms from the nodes of the crystal lattice to the interstitials, i.e. pairs of atomic defects vacancy-interstitial are formed.

Due to the fact that the binding energy of atoms in the crystal lattice is relatively high, the probability of the formation of a vacancy-interstitial pair is rather small. Therefore, to create a reliably detectable concentration thereof, a train of many ultrashort pulses is sent to the same focal region, resulting in a gradual accumulation of vacancies and interstitials. In practice, only a small excess of the concentration of vacancies and interstitials in the focus region over the natural (background) value in the crystal is sufficient. When vacancies drift, especially when the temperature rises, partial recombination thereof with interstitials is possible; however, it is known from practice that complete recombination does not occur within a reasonable time, and the concentration of vacancies and interstitials still remains elevated.

In this case, the energy of the laser pulses and their total number is chosen in such a way that there is no local transition to the non-diamond form of carbon with the formation of visible macroscopic damage to the crystal in the focus region.

Due to the extremely small absorption of light by vacancies and interstitials, as well as the relatively small increase in their concentration in the focus region, this region looks absolutely transparent and is indistinguishable from the rest of the crystal volume even under a strong microscope.

After the formation of one area of increased concentration of vacancies and interstitials, the focus region is moved inside the crystal to a new predetermined position (or the crystal itself is moved accordingly) and a new such an area is formed.

As a result of the sequence of such operations, the optically permeable mark is formed located inside the diamond volume and consisting of a given set of optically permeable (invisible under ordinary conditions) elements of micron or submicron size, wherein said elements represent areas of increased concentration of atomic defects in the crystal lattice, which are vacancies and interstitials.

Said mark can be read (detected) by its fluorescence under the influence of exciting optical radiation. To do this, the constant laser radiation of the blue or green range of the spectrum, which is most effective for exciting vacancies, is sent to the area of the expected location of the mark. Under the influence of said radiation, the mark elements begin to fluoresce in the red and near infrared ranges of the spectrum. To observe their fluorescence, a microscope equipped with a light filter is used, which blocks the exciting laser radiation and transmits the fluorescence radiation of the mark.

The information in the mark can be encoded in the mutual spatial arrangement of the mark elements, the combination of which can form a flat or three-dimensional image, a bar code, a QR code, a bit sequence, etc.

Information can also be encoded in variations in the concentration of atomic defects in said elements, in variations in the size or geometric shape of said elements. In this case, to control the concentration of atomic defects, the energy and/or total number of laser pulses exerting influence on the given region will be changed, and to control the size and geometric shape of the elements, the focusing conditions, for example, the focal length of the focusing element, will be changed, or the focus area will be slightly moved during the period of action of the train of laser pulses.

The main difference from the closest analogue, i.e. the mark created using the method for creation of an optically permeable image inside a diamond (RU2465377), is the fact that elements of said mark consist of new physical objects, i.e. vacancies and interstitials, rather than nitrogen-vacancy (NV) centers. This allows the use of the new mark on crystals with any nitrogen impurity content, and additionally, the mark creation process implies absence of annealing (in contrast to nitrogen-vacancy (NV) centers), which has positive effect on the simplification of the marking process and significantly reduces possible affecting the properties of the stone in the process of marking.

The invention is illustrated by drawings:
Figure 1 is a marking system for creation an optically permeable mark inside a diamond or brilliant;
Figure 2 is a single mark element, which is an area of increased concentration of atomic defects, i.e. vacancies and interstitials;
Figure 3 is a system for detection of an optically permeable mark.

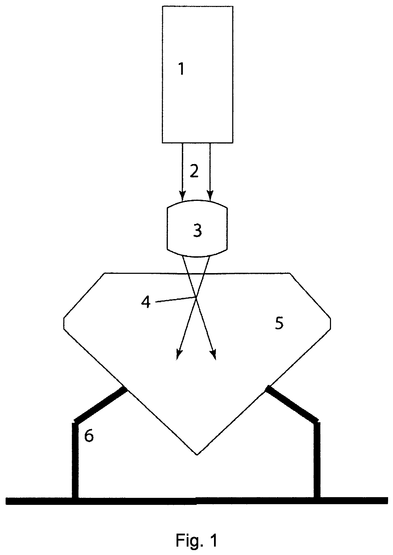

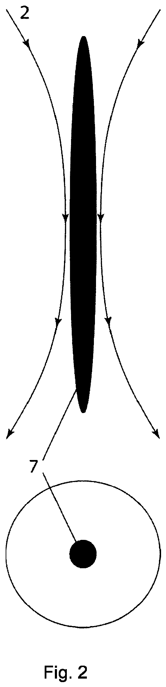

The laser 1 of the marking system (FIG. 1) generates working radiation 2 in the form of a train of pulses, with parameters at which diamond does not transform into graphite or another non-diamond form of carbon. Said radiation is focused by the focusing subsystem 3 (lens, objective) and creates a focal waist of the beam 4 in the focal region inside the volume of a diamond 5, on the surface of which a polished optically transparent culet was previously made. The diamond 5 is mounted on a subsystem for moving 6, which is configured to move along three spatial coordinates, and additionally two angular coordinates. Laser radiation 2 (FIG. 2) causes the formation of atomic defects in the area of micron or submicron size 7. The area 7 is a single element of the mark. After the mark element has been formed in a given area inside the diamond, the subsystem for moving the diamond moves the diamond in space in accordance with the digital model of the image to be recorded in the crystal volume entered by user, after which the above operations are repeated.

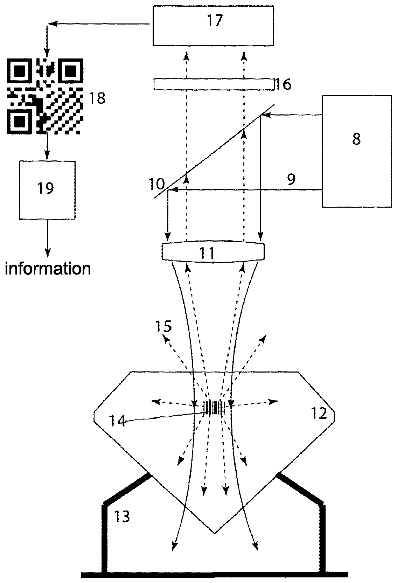

Detection of the previously created mark is carried out by fluorescence of atomic defects in the diamond crystal lattice, i.e. vacancies and interstitials, according to the scheme shown in (FIG. 3).

The system for detection (FIG. 3) of optically permeable marks comprises a laser 8 generating exciting optical radiation 9, which is reflected from a translucent mirror 10 and is focused by a focusing subsystem 11 inside a diamond 12, mounted on a subsystem for moving 13, which provides moving it in space along three spatial coordinates, and additionally two angular coordinates, to the area of the expected location of the mark 14. Moreover, the transverse size of a focal waist is greater than or equal to the transverse size of the mark.

As a result of optical excitation, the mark elements emit fluorescence radiation 15, part of which is collimated by the focusing subsystem 11, passes through the translucent mirror 10, then passes through a filter 16, which passes fluorescence radiation and blocks the scattered laser radiation. Then the radiation is registered by a registering subsystem 17, for example, a camera with a CCD matrix. The signal from the registering subsystem 17 containing the image of a fluorescent mark 18, is fed to the subsystem for registering and decoding of the signal 19, which displays information encoded in the mark.

## Claims

1. An optically permeable mark located inside the volume of a diamond or brilliant, which mark comprises predetermined encoded information and consists of a given set of optically permeable elements of micron or submicron size, which elements represents areas of an increased concentration of atomic defects in the crystal lattice of the diamond or brilliant,
*wherein*
atomic defects in the crystal lattice of the diamond or brilliant are vacancies and interstitials,
wherein said information is encoded in at least two areas of increased concentration of said atomic defects.

2. The mark according to claim 1, wherein the information is encoded in the mutual spatial arrangement of said areas.

3. The mark according to claim 1, wherein the information is encoded in variations in the concentration of said atomic defects in said areas.

4. The mark according to claim 1, wherein the information is encoded in variations in the size of said areas.

5. The mark according to claim 1, wherein the information is encoded in variations of the geometric shape of said areas.
